# EUROPEAN PATENT APPLICATION

(11) **EP 4 742 289 A1**
(43) Date of publication of application: **13.05.2026**
(21) Application number: 25215045.3
(22) Date of filing: 11.11.2025
(51) Int. Cl.: H01H 1/00, H01H 59/00

(54) **MEMS SWITCH, PACKAGED MEMS SWITCH PRODUCT AND METHOD OF OPERATING IT**

(30) Priority: 11.11.2024 US 202463718832 P
(71) Applicant: Infineon Technologies AG, 85579 Neubiberg (DE)
(72) Inventor: TIMME, Hans-Jörg, 85521 Ottobrunn (DE); LOHNINGER, Gerhard, 81825 München (DE); AHRENS, Carsten, 93059 Regensburg (DE)
(74) Representative: Kraus & Lederer PartGmbB

(57) **Abstract**

In accordance with an embodiment, a microelectromechanical system (MEMS) switch device includes: a substrate; a switching membrane disposed above the substrate; a pull-in electrode disposed above the switching membrane; a metal contact disposed on the switching membrane; and a pull-back electrode disposed below the switching membrane, wherein the switching membrane is movable between an open position and a closed position, and wherein in the closed position, the metal contact electrically connects two RF signal lines.

## Description

### TECHNICAL FIELD

The present invention relates generally to electronic systems, and, in particular embodiments, to a microelectromechanical systems (MEMS) switch.

### BACKGROUND

Radio frequency (RF) switches are common components in modern wireless communication systems, including smartphones, tablets, and other mobile devices. These switches enable the routing of RF signals between different components within a device, such as antennas, power amplifiers, and receivers. As wireless technologies continue to evolve and expand, there is an increasing demand for RF switches that can operate across a wide range of frequencies, handle higher power levels, and provide improved performance characteristics.

Traditional RF switches have typically been implemented using semiconductor technologies, such as PIN diodes or field-effect transistors (FETs). While these solid-state switches have been widely used, they often face limitations in terms of insertion loss, isolation, and power handling capabilities, particularly at higher frequencies.

In recent years, microelectromechanical systems (MEMS) technology has emerged as a promising alternative for implementing RF switches. MEMS-based RF switches offer several potential advantages over their solid-state counterparts, including lower insertion loss, higher isolation, and better linearity. These characteristics make MEMS switches particularly attractive for applications requiring high performance and low power consumption.

However, the development and implementation of MEMS RF switches present several challenges. These include ensuring reliable and consistent switch operation over millions of cycles, managing issues related to stiction and wear of contact surfaces, and developing efficient manufacturing processes that can produce these devices at scale. Additionally, integrating MEMS switches into existing semiconductor manufacturing processes and packaging technologies poses further challenges that need to be addressed.

As wireless devices continue to incorporate an increasing number of frequency bands and antennas, the need for compact, high-performance RF switching solutions becomes more critical. This drives the ongoing research and development efforts to create innovative MEMS switch designs that can meet the demanding requirements of next-generation wireless communication systems.

### SUMMARY

According to some embodiments, a microelectromechanical system switch device as defined in claim 1, a packaged microelectromechanical system switch product as defined in claim 8 and a method as defined in claim 12 are provided. The dependent claims define further embodiments. The methods may be performed using the switch devices and switch products.

In accordance with an embodiment, a microelectromechanical system (MEMS) switch device includes: a substrate; a switching membrane disposed above the substrate; a pull-in electrode disposed above the switching membrane; a metal contact disposed on the switching membrane; and a pull-back electrode disposed below the switching membrane, wherein the switching membrane is movable between an open position and a closed position, and wherein in the closed position, the metal contact electrically connects two RF signal lines.

In accordance with another embodiment, a method of operating a microelectromechanical system (MEMS) switch device includes: applying a first voltage between a switching membrane and a pull-in electrode to move the switching membrane from an open position to a closed position, wherein in the closed position a metal contact on the switching membrane electrically connects two RF signal lines disposed on the pull-in electrode; and applying a second voltage between the switching membrane and a pull-back electrode to move a switch formed by the metal contact and the RF signal lines from the closed position to the open position.

In accordance with another embodiment, a wafer-level encapsulated microelectromechanical system (MEMS) switch device includes: a substrate; a switching membrane disposed above the substrate; a pull-in electrode disposed above the switching membrane; a metal contact disposed on the switching membrane; a sealed cavity enclosing the switching membrane; and pillar structures extending from the substrate to support the pull-in electrode, wherein the switching membrane is movable between an open position and a closed position within the sealed cavity.

In accordance with a further embodiment, a microelectromechanical system (MEMS) single pole double throw (SPDT) switch device includes: an upper pull-in electrode comprising a first electrical contact; a switching membrane disposed below the upper pull-in electrode and comprising a second electrical contact disposed on a first surface of the switching membrane facing the upper pull-in electrode, and a third electrical contact disposed on a second surface of the switching membrane opposite the first surface; and a lower pull-in electrode disposed below the switching membrane and comprising a fourth electrical contact, wherein the switching membrane is movable between a first position in which the first electrical contact makes physical contact with the second electrical contact, and a second position in which the third electrical contact makes contact with the fourth electrical contact.

### BRIEF DESCRIPTION OF THE DRAWINGS

For a more complete understanding of the present invention, and the advantages thereof, reference is now made to the following descriptions taken in conjunction with the accompanying drawings, in which:
Figure 1 illustrates a cross-sectional view of an RF MEMS switch in an open state, according to aspects of the present disclosure;
Figure 2A depicts a cross-sectional view of the RF MEMS switch in a closed state, according to an embodiment; and Figure 2B shows cross-sectional views of the RF MEMS switch in open and closed states, according to aspects of the present disclosure;
Figure 3 illustrates a cross-sectional view of the RF MEMS switch in a closed state with strong contact, according to an embodiment;
Figure 4A depicts a cross-sectional view of the RF MEMS switch in an open state with pull-down, according to aspects of the present disclosure; and Figure 4B shows a cross-sectional view of the RF MEMS switch in a closed state due to sticking, according to an embodiment;
Figure 5 illustrates a cross-sectional view of the RF MEMS switch with a pull-back electrode option, according to aspects of the present disclosure;
Figure 6 depicts a cross-sectional view of the RF MEMS switch with a metal line configuration option and a pull-back electrode configuration, according to an embodiment;
Figure 7 shows a cross-sectional view of the RF MEMS switch with a metal line configuration and an alternative pull-back electrode configuration, according to aspects of the present disclosure;
Figure 8 illustrates a cross-sectional view of the RF MEMS switch with a sealed vacuum cavity, according to an embodiment;
Figure 9 depicts another cross-sectional view of the RF MEMS switch with a sealed vacuum cavity, according to aspects of the present disclosure;
Figure 10 shows a further cross-sectional view of the RF MEMS switch with a sealed vacuum cavity, according to an embodiment;
Figure 11A illustrates a top view of the RF MEMS switch, according to aspects of the present disclosure; and Figure 11B depicts a top view of an SP3T RF MEMS switch configuration, according to an embodiment;
Figure 12A shows a cross-sectional view of the RF MEMS switch with a piezoelectric layer disposed on the pull-in electrode; and Figure 12B shows a cross-sectional view of the RF MEMS switch with a piezoelectric layer disposed on membrane, according to aspects of the present disclosure;
Figures 13A and 13B illustrate operational states of the RF MEMS switch with piezoelectric-assisted contact release, according to embodiments;
Figures 14A and 14B show top views of RF MEMS switches with piezoelectric pull-out functionality, according to embodiments; and Figure 14C shows cross-sectional diagrams of the RF MEMS switches shown in Figures 14A and 14B;
Figure 15 illustrates a cross-sectional view of the RF MEMS switch in an upside-down configuration, according to aspects of the present disclosure;
Figures 16A and 16B illustrates a cross-sectional views of a RF MEMS SPDT switch, according to aspects of the present disclosure; and
Figure 17 illustrates an architecture for a packaged RF MEMS switch and CMOS die, according to aspects of the present disclosure.

### DETAILED DESCRIPTION OF ILLUSTRATIVE EMBODIMENTS

The present disclosure relates to radio frequency (RF) microelectromechanical system (MEMS) switch devices and methods of operation thereof. In some aspects, RF MEMS switch devices may include a substrate, a switching membrane disposed above the substrate, a pull-in electrode disposed above the switching membrane, a metal contact disposed on the switching membrane, and a pull-back electrode disposed below the switching membrane. The switching membrane may be movable between an open position and a closed position. In the closed position, the metal contact may electrically connect two RF signal lines.

In some cases, RF MEMS switch devices may be utilized in wireless communication systems, such as smartphones, to enable antenna tuning across multiple frequency bands. The RF MEMS switch devices may provide low insertion loss when closed and high isolation when open. In certain aspects, the RF MEMS switch devices may operate with low activation voltages and exhibit improved reliability over multiple switching cycles.

RF MEMS switch devices may, in some implementations, include features to assist with switch opening and closing. For example, anti-sticking bumps may be disposed on the switching membrane. The switching membrane may be perforated in some cases to reduce mass and increase switching speed. Segmentation lines may electrically isolate the metal contact from the switching membrane in certain configurations.

Some aspects of RF MEMS switch devices may include wafer-level encapsulation. Pillar structures may extend from the substrate to the pull-in electrode in some implementations. A sealed vacuum cavity may be formed between the pull-in electrode and the substrate in certain cases. The sealed cavity may protect internal switch components from environmental contaminants.

In some implementations, RF MEMS switch devices may incorporate piezoelectric actuation. A piezoelectric layer may be disposed on the switching membrane or pull-in electrode. The piezoelectric layer may bend the switching membrane or pull-in electrode to assist with switch opening in certain aspects.

Methods of operating RF MEMS switch devices may involve applying voltages to move the switching membrane between open and closed positions. In some cases, a first voltage may be applied between the switching membrane and pull-in electrode to close the switch. A second voltage may be applied between the switching membrane and pull-back electrode to open the switch. Additional voltages may be applied to piezoelectric layers in certain implementations to further assist with switch actuation.

RF MEMS switch devices may offer several advantages over traditional metal-oxide-semiconductor (MOS) switches in certain applications. In some aspects, RF MEMS switches may provide lower insertion loss and higher linearity when closed and higher isolation when open compared to MOS switches. This improved RF performance may be attributed to the air gap between contacts in the open state and the metal-to-metal contact in the closed state of RF MEMS switches. Additionally, RF MEMS switches may exhibit lower parasitic capacitance, potentially enabling operation at higher frequencies. In some implementations, RF MEMS switches may consume less power than MOS switches, as they may not require a constant bias current to maintain the on or off state. The mechanical nature of RF MEMS switches may also allow them to handle higher power levels in certain cases. While MOS switches may offer faster switching speeds in some applications, the overall performance characteristics of RF MEMS switches may make them well-suited for specific RF applications, such as antenna tuning in mobile devices.

In some aspects, embodiments of the present invention may be advantageously implemented using existing MEMS microphone manufacturing processes. The RF MEMS switch devices may utilize similar materials, structures, and fabrication techniques as those employed in the production of MEMS microphones. For example, the switching membrane may be formed using the same polysilicon deposition and patterning steps used to create microphone diaphragms. The pull-in and pull-back electrodes may be fabricated using processes analogous to those used for microphone backplates. In some implementations, the wafer-level encapsulation and pillar structures may be adapted from established microphone packaging techniques. This compatibility with MEMS microphone processes may allow for efficient integration of RF MEMS switches into existing production lines, potentially reducing manufacturing costs and time-to-market. Additionally, the use of proven microphone fabrication methods may contribute to the reliability and consistency of the RF MEMS switch devices. In some embodiments, a microphone manufacturing process, such as those described in U.S. Patent No. 9,309,105 and/or U.S. Patent No. 10,689,250, which have been incorporated herein by reference, can be used to manufacture embodiments described herein.

In some aspects, the pillar structures used in MEMS microphone processes may be adapted for use in RF MEMS switch devices in the embodiments described below. While microphone pillars typically span between two backplates or two membranes, the pillars in RF MEMS switch devices may extend from the substrate to the pull-in electrode. This modification may provide structural support and maintain a precise spacing between the substrate and the pull-in electrode. The pillars may be fabricated using similar materials and deposition techniques as those employed in microphone manufacturing, such as silicon nitride or polysilicon. In some implementations, the pillars may be designed to withstand the mechanical stresses associated with switch actuation and provide stability to the overall device structure. The placement and dimensions of the pillars may be optimized to balance structural integrity with the need for membrane flexibility in the switching area. In certain cases, the pillars may also serve as anchor points for the pull-in electrode, ensuring its proper alignment and preventing unwanted movement during switch operation. The integration of these adapted pillar structures may contribute to the robustness and reliability of RF MEMS switch devices while leveraging existing microphone manufacturing expertise.

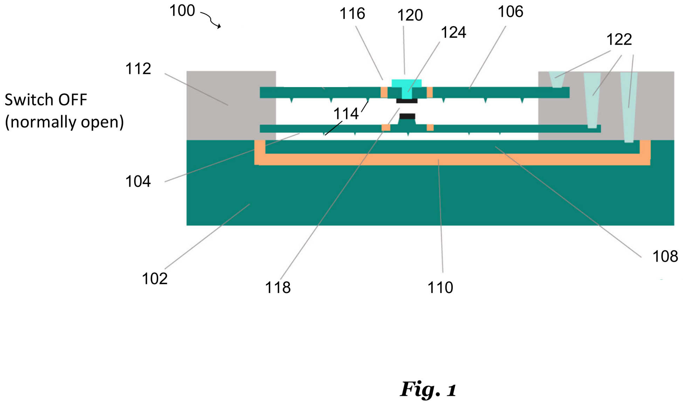

Figure 1 illustrates a cross-sectional view of an RF MEMS switch device 100 having a multilayer structure built on a substrate 102. The device 100 includes a switching membrane 104 disposed above the substrate 102, a pull-in electrode 106 disposed above the switching membrane 104, and a pull-back electrode 108 integrated within the substrate 102. The substrate 102 serves as the foundation for the RF MEMS switch device 100 and may be made of silicon, though other suitable materials may be used. The substrate 102 provides mechanical support for the other components and incorporates additional functional elements, particularly the pull-back electrode 108 which is implemented as a highly-doped area within the substrate 102.

An isolation layer 110 is disposed between the substrate 102 and the active components of the switch. This isolation layer 110 may be implemented as either a dielectric film or a pn junction. When implemented as a dielectric film, materials such as silicon dioxide or silicon nitride may be used. Alternatively, the isolation may be achieved using a reverse-biased pn junction between the substrate 102 and the active device layers. The isolation layer 110 serves to minimize parasitic capacitances and reduce unwanted coupling between the substrate 102 and the switch components.

The switching membrane 104 comprises a thin, flexible structure made of polysilicon with a thickness of approximately 500 nanometers. The membrane 104 includes perforations distributed across its surface, which serve multiple purposes including reducing the overall mass of the membrane 104 to increase switching speed and facilitating membrane release during fabrication processes. Anti-sticking bumps 114 are disposed on the lower surface of the switching membrane 104 to prevent unwanted adhesion during switch operation. The membrane 104 also includes segmentation lines 116 that electrically isolate different sections of the device.

Contact metals 118 are disposed on the switching membrane 104, typically composed of tungsten or titanium tungsten or ruthenium. These contacts 118 provide low contact resistance when the switch is closed while exhibiting good wear resistance over multiple switching cycles. The dimensions of these contacts 118 may be optimized to balance electrical performance and mechanical reliability in some embodiments.

The pull-in electrode 106 disposed above the switching membrane 104 may be implemented as a stiff backplate structure, and may be made thicker and stiffer than the switching membrane 104, with a thickness ranging from a few hundred nanometers to tens of microns. In some embodiments, the thickness of the pull-in electrode 106 is between about 600 nanometers and 700 nanometers. The pull-in electrode 106 may include polysilicon and silicon nitride layers, which may make the pull-in electrode 106 more stiff than the switching membrane 104 because of high tensile stress. The polysilicon may be heavily doped to ensure good conductivity. In some embodiments, the pull-in electrode 106 may include metal for conductivity. Metal lines 120 are disposed on the top surface of the pull-in electrode 106, with segmentation lines 116 providing electrical isolation between these metal lines 120 and the rest of the electrode structure. In the figure, the metal lines in the contact area are perpendicular to the cross section plane.

Support structures 112, made of materials such as tetraethyl orthosilicate (TEOS) or silicon nitride (SiN), are incorporated into the device architecture. These structures 112 provide mechanical stability to the various layers and act as spacers between the substrate 102 and upper layers. The support structures 112 incorporate contact vias for the electrodes, allowing electrical connections between different layers to the different electrodes of the device. In some implementations, these support structures 112 may also contribute to hermetic sealing of the device.

Conductive vias 122 are integrated throughout the device to establish electrical connections between different layers. These vias 122 comprise vertical conductive pathways that pass through insulating layers, enabling the transmission of electrical signals and control voltages between various components. The vias 122 may be fabricated using electrically conductive materials such as heavily doped polysilicon or metals like tungsten, or copper, with their dimensions and placement optimized to minimize parasitic effects while maintaining structural integrity.

In operation, the device 100 functions as a normally-open switch, with the switching membrane 104 moving between open and closed positions through electrostatic actuation. When a voltage is applied between the pull-in electrode 106 and the switching membrane 104, the flexible membrane 104 deforms and moves toward the stiffer pull-in electrode 106, closing the switch. The pull-back electrode 108 assists in returning the membrane 104 to its open position by providing an opposing electrostatic force.

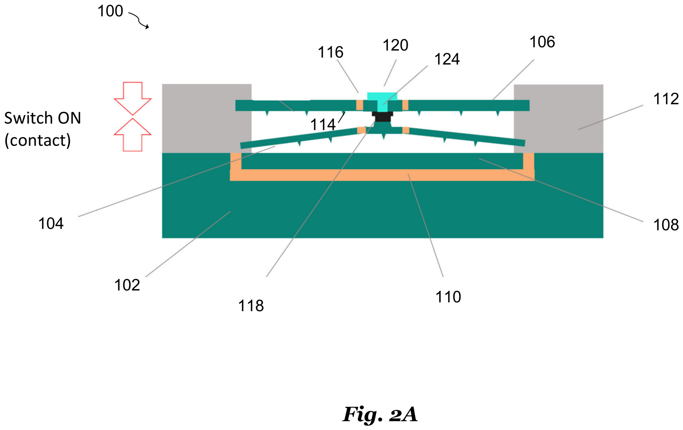

Referring to Figure 2A, the RF MEMS switch device 100 is shown in a closed (ON) state. In this configuration, the switching membrane 104 may be deflected towards the pull-in electrode 106, causing the metal contact 118 on the switching membrane 104 to make electrical connection with two RF signal lines. The switching membrane 104 may move from an open position to this closed position in response to application of a first voltage between the switching membrane 104 and the pull-in electrode 106.

In some aspects, the first voltage may create an electrostatic attractive force between the switching membrane 104 and the pull-in electrode 106. This electrostatic force may overcome the mechanical restoring force of the switching membrane 104, causing it to deflect upwards. The magnitude of the first voltage may be selected based on factors such as the gap distance between the membrane 104 and pull-in electrode 106, the mechanical properties of the membrane 104, and the desired contact force.

When in the closed position, the metal contact 118 disposed on the switching membrane 104 may physically touch and electrically connect two RF signal lines (not shown). These RF signal lines may be disposed on the pull-in electrode 106 or on a separate layer. In some implementations, the metal contact 118 may bridge across a small gap between two separate RF signal line segments, completing an electrical path for RF signals to flow. The contact resistance between the metal contact 118 and the RF signal lines may be minimized through careful selection of contact materials and applied contact force in some embodiments.

As shown, anti-sticking bumps 114 below the pull-in electrode 106 may help prevent unwanted adhesion between the membrane 104 and pull-in electrode 106 in areas surrounding the metal contact 118. Perforations in the switching membrane 104 may allow for faster actuation by reducing air damping effects. Segmentation lines 116 may electrically isolate the metal contact region from the rest of the membrane 104, minimizing parasitic capacitances.

The deflection profile of the switching membrane 104 in the closed state may vary depending on the specific design. In some implementations, the membrane 104 may exhibit a relatively uniform upward deflection. In other cases, the membrane 104 may have a more pronounced curvature, with maximum deflection occurring in the region of the metal contact 118. The exact deflection characteristics may be tuned through factors such as membrane thickness, intrinsic stress, and electrode geometry to optimize contact force and RF performance.

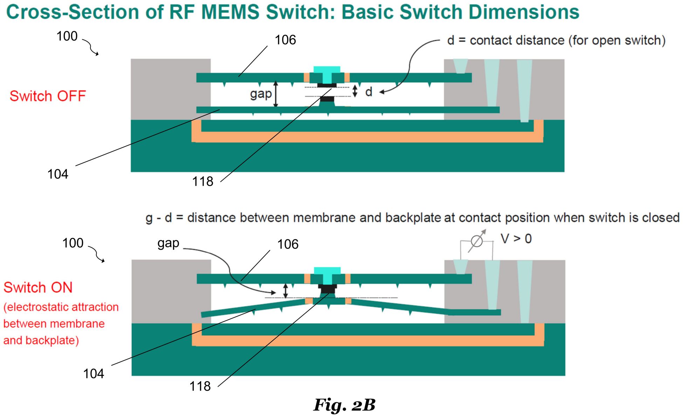

Referring to Figure 2B, the RF MEMS switch device 100 is shown in both its open (OFF) and closed (ON) states, illustrating key dimensional parameters that influence the switch's operation. In the open state, the switching membrane 104 may be positioned at its resting height above the substrate 102. The gap 202 between the switching membrane 104 and the pull-in electrode 106 in this open position may be 2 µm or more in some implementations. This relatively large gap distance when the switch is OFF may contribute to high isolation between the RF signal lines.

The distance between the metal contact 118 on the switching membrane 104 and the RF signal lines on the pull-in electrode 106 when the switch is open may be denoted as 'd'. This contact distance 'd' may be optimized to balance isolation in the OFF state with the actuation voltage required to close the switch. In some aspects, a larger 'd' value may provide better isolation but may necessitate a higher actuation voltage.

When the switch transitions to the closed (ON) state, the switching membrane 104 may deflect upward due to electrostatic attraction between the membrane 104 and the pull-in electrode 106. The distance between the membrane 104 and the pull-in electrode 106 at the contact position in the closed state may be represented as 'g - d', where 'g' is the total gap height. This 'g - d' distance may be dimensioned to ensure proper contact force and low contact resistance when the switch is closed.

The relationship between these key dimensions - the total gap height 'g', the contact distance 'd', and the closed state distance 'g - d' - may play a role in determining the switch's performance characteristics. In some implementations, the ratio of 'd' to 'g' may be optimized to achieve a desired balance between isolation in the OFF state and actuation voltage, as the isolation (characterized by the off capacitance) in the switch is affected by the distance 'd,' and the actuation force and hence the actuation voltage is dependent on the gap height 'g.' For example, a d/g ratio of approximately 1/3 may provide a good compromise in certain designs. In some embodiments, an effective ratio may allow for a so-called "pull-in" of the membrane, in which the attractive electrostatic forces cannot be counterbalanced by the mechanical restoring forces of the switching membrane. This happens for actuation voltages at or above the so-called pull-in voltage Vp, and guaranties a closing of the switch by an instantaneous "snapping" of the switching membrane to the pull-in electrode, thereby providing a snapping contact between the metal contact on the switching membrane and the metal RF line segments of the pull-in electrode. It should be appreciated that the ratio of 1/3 is just one example of a possible d/g ratio. In alternative embodiment this ratio may be different depending on the particular semiconductor process and device structure.

The mechanical compliance of the switching membrane 104, combined with these dimensional parameters, may influence the voltage required to actuate the switch. In some aspects, a more compliant membrane 104 may allow for lower actuation voltages but may also impact the switch's mechanical stability and reliability. The membrane compliance and gap dimensions may be tuned in conjunction to achieve desired performance targets such as actuation voltage, switching speed, and contact force.

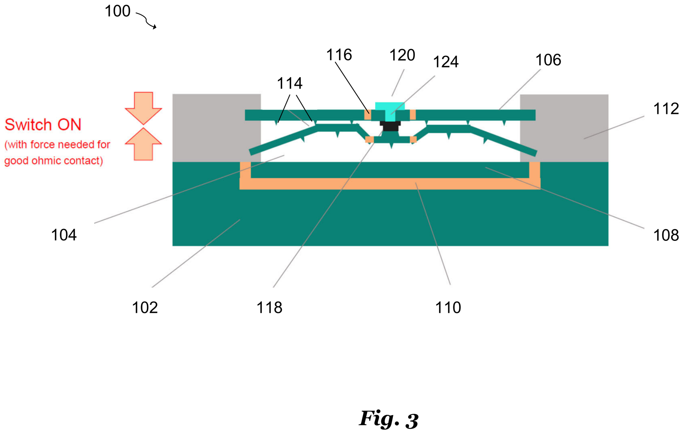

Referring to Figure 3, the RF MEMS switch device 100 is shown in a closed (ON) state with strong contact force applied. In this configuration, the switching membrane 104 may be significantly deflected towards the pull-in electrode 106, creating a robust electrical connection between the metal contact 118 and the RF signal lines.

In some aspects, the deflection of the switching membrane 104 may be more pronounced compared to the basic closed state shown in Figure 2A. This increased deflection may result from applying a higher voltage between the switching membrane 104 and the pull-in electrode 106. The stronger electrostatic force may cause the membrane 104 to bend further, potentially bringing it into contact with anti-sticking bumps 114 located on the pull-in electrode 106 surface.

The anti-sticking bumps 114 may serve multiple purposes in this strongly actuated state. In some implementations, they may act as mechanical stops, preventing direct contact between large areas of the switching membrane 104 and the pull-in electrode 106. This may help avoid stiction issues that could interfere with switch opening. Additionally, the bumps 114 may concentrate the contact force on the metal contact 118 area, potentially improving the electrical connection.

Segmentation lines 116 may play a role in this strongly actuated state. These lines 116 may electrically isolate the metal contact 118 region from the rest of the membrane 104, which may be in closer proximity to the pull-in electrode 106. This isolation may help maintain the RF performance of the switch by minimizing parasitic capacitances that could arise from the increased membrane deflection.

The contact force in this state may be higher than in the basic closed state. In some aspects, this increased force may lead to lower contact resistance and improved RF performance. However, the design may need to balance this improved performance against potential wear on the contact surfaces over multiple switching cycles.

In certain implementations, the strong actuation may cause the membrane 104 to conform more closely to the underlying electrode structure. This may result in a larger effective capacitance between the membrane 104 and the pull-in electrode 106, which may need to be considered in the overall RF design of the switch.

The ability to achieve this strongly actuated state may provide flexibility in switch operation. In some cases, the switch may be operated in a basic closed state for normal operation, with the option to apply higher voltages for a stronger contact when needed for specific applications or to overcome contact degradation over time.

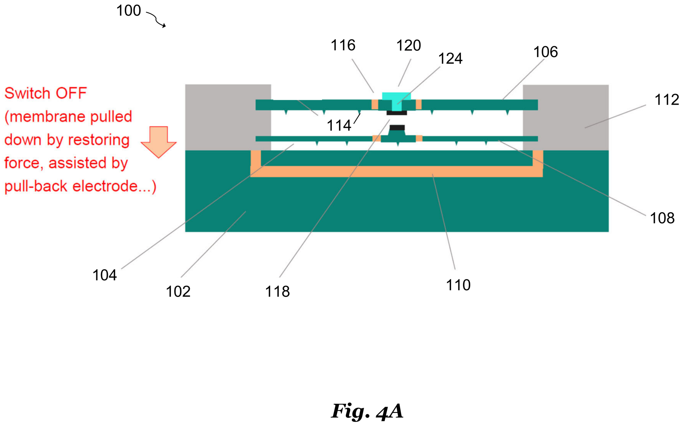

Referring to Figure 4A, the RF MEMS switch device 100 is shown in an open (OFF) state. In this configuration, the switching membrane 104 may be positioned in its resting state above the substrate 102, with the metal contact 118 separated from the RF signal lines. The switching membrane 104 may move from a closed position to this open position in response to the removal of voltage between the switching membrane 104 and the pull-in electrode 106, as well as the application of a second voltage between the switching membrane 104 and the pull-back electrode 108.

In some aspects, when transitioning from a closed to open state, the electrostatic attractive force between the switching membrane 104 and the pull-in electrode 106 may be removed by setting the voltage between them to zero. This allows the inherent mechanical restoring force of the switching membrane 104 to begin moving the membrane 104 back towards its resting position. The mechanical restoring force may result from the tensile stress built into the membrane material during fabrication.

To assist in opening the switch and overcoming any potential stiction forces between the metal contact 118 and RF signal lines, a second voltage may be applied between the switching membrane 104 and the pull-back electrode 108. This second voltage may create an electrostatic attractive force between the membrane 104 and the pull-back electrode 108, pulling the membrane 104 downward and away from the pull-in electrode 106. The magnitude of this second voltage may be selected based on factors such as the distance between the membrane 104 and pull-back electrode 108, the mechanical properties of the membrane 104, and the strength of any contact adhesion forces that need to be overcome.

In some implementations, the pull-back electrode 108 may be integrated into the substrate 102 as a highly-doped area. This integration may allow for a compact device structure while still providing effective pull-back functionality. An isolation layer 110 between the substrate 102 and the pull-back electrode 108 may prevent direct electrical contact between the pull-back electrode 108 and other device components. Contact area and potential adhesion forces between the membrane 104 and the pull-back electrode 108 are minimized due to a large number of tiny bumps placed on the lower side of the switching membrane 104. Such bumps can also provide for electrical isolation between the switching membrane 104 and the pull-back electrode 108. In various embodiments, these bumps may include a hull of silicon nitride, which is an insulator.

The perforations in the switching membrane 104 may play a role in the switch opening process. These perforations may reduce air damping effects, potentially allowing for faster switch opening times. In some aspects, the size and distribution of these perforations may be optimized to balance mechanical properties, switching speed, and RF performance.

Anti-sticking bumps 114 below the pull-in electrode (backplate) 106 or on the switching membrane 104 may help prevent unwanted adhesion to the pull-in electrode 106 as the membrane 104 returns to its open position. In some cases, these bumps 114 may make initial contact with the pull-in electrode 106 during switch closing, reducing the contact area between the membrane 104 and electrode 106 and facilitating easier separation during opening.

The exact profile of the switching membrane 104 in the open state may depend on various design factors. In some implementations, the membrane 104 may return to a perfectly flat state.

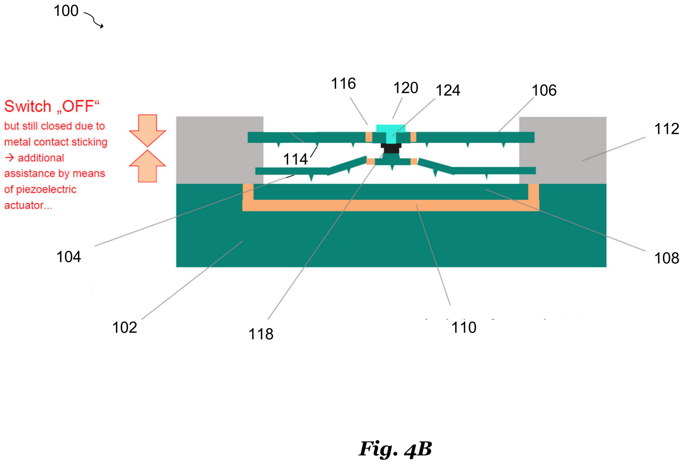

Referring to Figure 4B, the RF MEMS switch device 100 may be in an "OFF" state but still closed due to contact sticking. In this configuration, the metal contact on the switching membrane 104 may remain in contact with the RF signal lines even after the voltage between the membrane 104 and pull-in electrode 106 has been removed. This undesired adhesion may occur due to various factors such as surface energy, contamination, or micro-welding at the contact interface.

In some aspects, the mechanical restoring force of the switching membrane 104 alone may be insufficient to overcome these adhesion forces. Hence, the pull-back electrode 108 may play a role in addressing this issue. By applying a voltage between the switching membrane 104 and the pull-back electrode 108, an additional electrostatic force may be generated to assist in separating the contacts. The magnitude of this voltage may be tuned based on the strength of the adhesion forces and the mechanical properties of the membrane 104 and the gap between the membrane 104 and the pull-back electrode 108.

In certain implementations, a piezoelectric actuator may be incorporated to provide further assistance in overcoming contact sticking. This piezoelectric element may be disposed on the switching membrane 104 or the pull-in electrode 106 as will be explained in embodiments below. When activated, the piezoelectric layer may induce a bending moment, creating an additional mechanical force to separate the contacts.

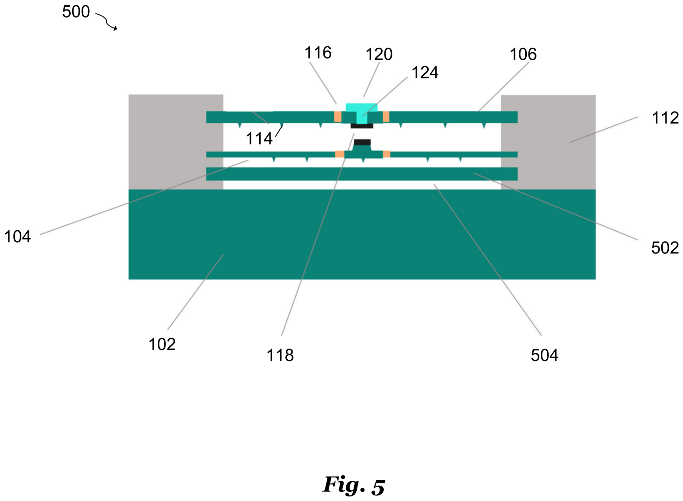

Referring to Figure 5, an alternative configuration of the RF MEMS switch device 500 is shown with a modified pull-back electrode arrangement. In this configuration, the pull-back electrode 502 may be implemented as a separate layer above the substrate 102 rather than being integrated into the substrate 102 itself.

In some aspects, the pull-back electrode 502 may comprise a polysilicon layer deposited on top of an isolation layer 504 above the substrate 102. This polysilicon layer may be heavily doped to increase its electrical conductivity. The thickness of the pull-back electrode layer 502 may range from a few hundred nanometers to a few micrometers, depending on the specific design requirements.

By implementing the pull-back electrode 502 as a separate layer, greater flexibility in electrode design and placement may be achieved. In some implementations, the geometry and dimensions of the pull-back electrode 502 may be optimized independently of substrate constraints. This may allow for more precise control over the electrostatic forces used to assist in switch opening.

The switching membrane 104, support structures 112, and other components of the RF MEMS switch device 500 may remain similar to those described in previous configurations. However, the placement of a separate pull-back electrode layer 502 may influence the overall stack height of the device. In some cases, this may require adjustments to other layer thicknesses or gap distances to maintain desired switch performance characteristics.

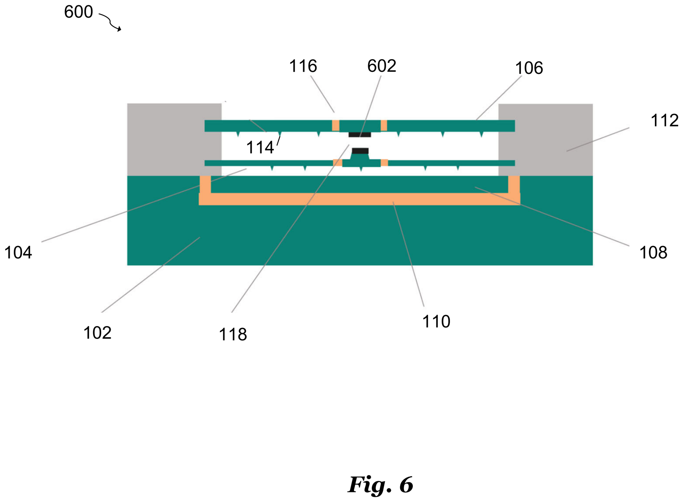

Referring to Figure 6, an alternative configuration of the RF MEMS switch device 600 may be implemented with metal lines 602 for RF signals placed below the pull-in electrode 106 instead of on top. The metal lines 602 in this configuration may be made of conductive materials such as tungsten, which is a metal that can withstand higher processing temperatures used for the subsequent processing of the pull-in electrode 106.

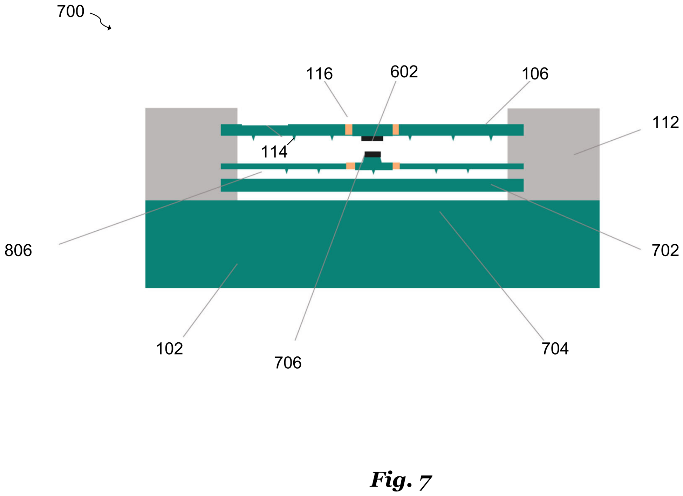

Referring to Figure 7, an alternative configuration of the RF MEMS switch device 700 may be implemented with metal lines 602 for RF signals placed below the pull-in electrode 106. This configuration is similar to Figure 6, with the exception that the pull-back electrode 702 is suspended above the substrate 102 in a manner similar to Figure 5.

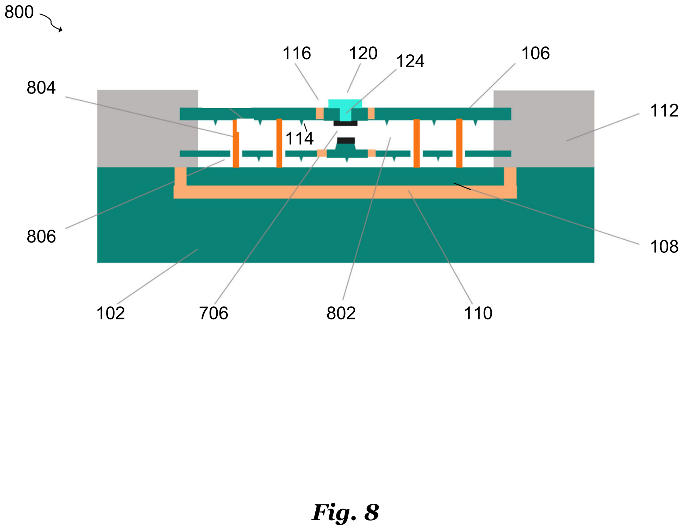

Referring to Figure 8, a wafer-level encapsulated RF MEMS switch device 800 may be implemented with a sealed cavity 802 containing a gas at low pressure or a vacuum. In some aspects, the device 800 may comprise a substrate 102, a switching membrane 104 disposed above the substrate 102, a pull-in electrode 106 disposed above the switching membrane 104, and a sealed cavity 802 enclosing the switching membrane 104. The sealed cavity 802 may be formed between the pull-in electrode 106 and the substrate 102.

In some implementations, the sealed cavity 802 may be maintained under vacuum conditions. Maintaining a sealed vacuum cavity 802 between the pull-in electrode 106 and the substrate 102 may protect the switch from environmental contaminants such as moisture, dust, or other particles that could interfere with switch operation. The vacuum environment may also reduce air damping effects, potentially allowing for faster switching speeds.

The wafer-level encapsulation process may allow the RF MEMS switch device 800 to be encapsulated at the wafer level before being packaged, for example, in a standard plastic molded package. This approach may provide several benefits, including protection of sensitive switch components during subsequent manufacturing steps and improved long-term reliability.

The switching membrane 104 may be movable between an open position and a closed position within the sealed cavity 802. The vacuum environment within the cavity 802 may reduce air resistance during membrane movement, potentially improving switching speed and reliability. In some implementations, the dimensions of the sealed cavity 802 may be optimized to allow for sufficient membrane movement while minimizing the overall device footprint.

The sealed cavity 802 design may allow for the integration of additional features within the protected environment. For example, anti-sticking bumps 114, segmentation lines 116, and perforations in the switching membrane 104 may all be enclosed within the sealed cavity 802.

In some aspects, the RF MEMS switch device 800 may further comprise pillar structures 804 extending from the substrate 102 to the pull-in electrode 106. These pillar structures 804 may provide mechanical support for the pull-in electrode 106 while maintaining the sealed cavity 802. The pillars 804 may be designed to withstand the mechanical stresses associated with switch actuation and packaging processes and, of course, with atmospheric pressure.

In certain implementations, the pillar structures 804 may extend from the substrate 102 to support the pull-in electrode 106. The pillars 804 may be fabricated using materials such as silicon nitride or polysilicon, similar to those used in MEMS microphone manufacturing processes. In one embodiment, each pillar 804 includes a hull of silicon nitride having an inner part filled with polysilicon. The height of the pillars 804 may be controlled to maintain a specific gap distance between the substrate 102 and the pull-in electrode 106.

The pillar structures 804 may provide no electrical connection between electrodes. In some aspects, the pillars 804 may be composed of dielectric materials to ensure electrical isolation between the substrate 102 and the pull-in electrode 106. This isolation may help minimize parasitic capacitances and maintain the RF performance of the switch.

In some implementations, the pull-back electrode 108 may be integrated into the substrate 102 as a highly-doped area. This integration may allow for a compact device structure while still providing effective pull-back functionality. The highly-doped area may be created through ion implantation or diffusion processes, resulting in a conductive region within the substrate 102 that can serve as the pull-back electrode 108.

The placement, dimensions and number of the pillar structures 804 may be implemented to balance structural integrity with the need for membrane flexibility in the switching area. Perforation holes present in the membrane 104 at and around the locations of the individual pillars 804 are included to help prevent the pillars 804 from affecting the movement of the switching membrane 104. The diameter and spacing of the pillars 804 may be tuned to provide adequate support while minimizing their impact on device performance.

In certain aspects, the pillar structures 804 may also serve as anchor points for the pull-in electrode 106, ensuring its proper alignment and preventing unwanted movement during switch operation. The interface between the pillars 804 and the pull-in electrode 106 may be designed to provide a secure mechanical connection while maintaining electrical isolation.

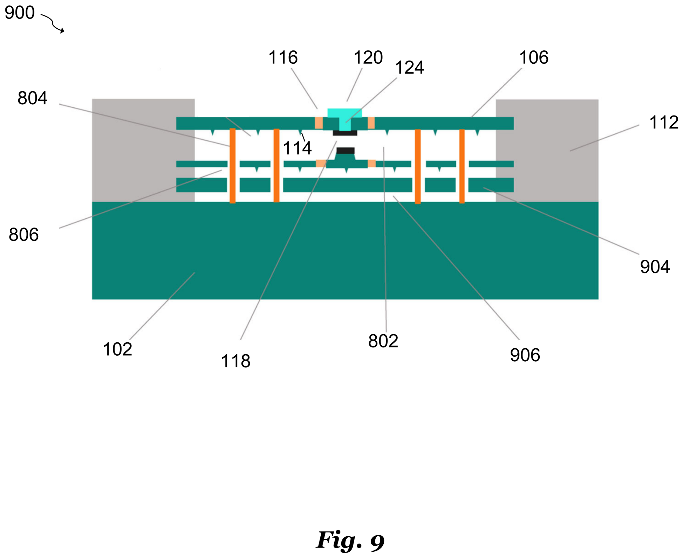

Referring to Figure 9, an alternative configuration of the wafer-level encapsulated RF MEMS switch device 900 may be implemented with a suspended pull-back electrode 904. This configuration is similar to the device 800 shown in Figure 8, with the key difference being the placement and structure of the pull-back electrode 904. In some aspects, the pull-back electrode 904 may be suspended above the substrate 902 rather than being integrated into it. The suspended pull-back electrode 904 may be formed as a separate layer, similar to the configuration shown in Figure 5. In some embodiments, an insulating layer may be disposed between the pull-back electrode 904 and the substrate 902. This suspended electrode 904 may be composed of a conductive material such as heavily doped polysilicon or a metal layer.

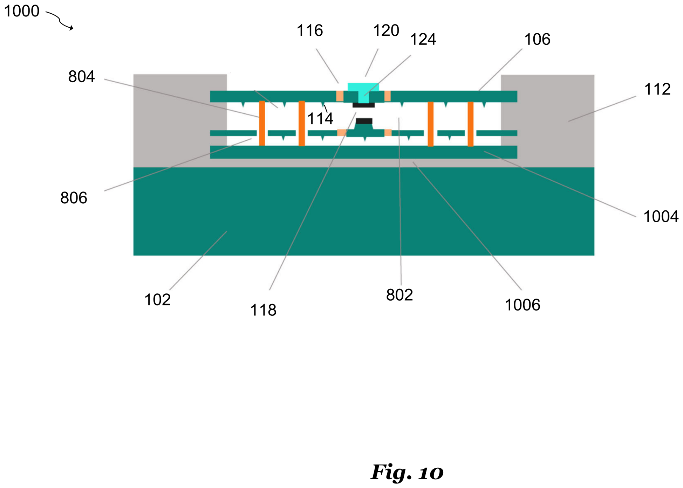

Referring to Figure 10, an alternative configuration of the wafer-level encapsulated RF MEMS switch device 1000 may be implemented with a sealed vacuum cavity 802 and an insulating layer 1006 between the pull-back electrode 1004 and the substrate 806. This configuration is similar to the device 900 shown in Figure 9, with the addition of an insulating material, such as an oxide layer, disposed between the pull-back electrode 1004 and the substrate 806.

In some aspects, the insulating layer 1006 may provide electrical isolation between the pull-back electrode 1004 and the substrate 806. This isolation may help reduce parasitic capacitances and improve the overall RF performance of the switch. The insulating layer 1006 may be composed of materials such as silicon dioxide, silicon nitride, or other suitable dielectric materials commonly used in semiconductor manufacturing processes. The insulating layer 1006 may also provide structural stability. In some aspects, the pillar structures 804 may extend until the pull-back electrode 1004 as shown. Alternatively, the pillar structures 804 may extend to the substrate 806.

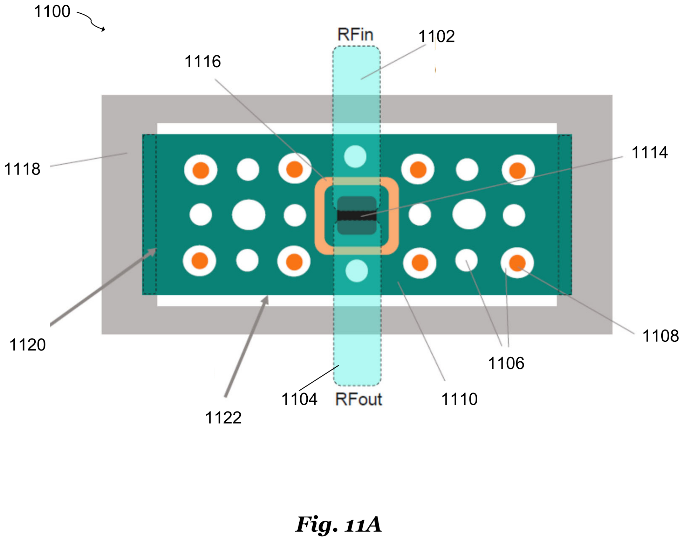

Referring to Figure 11A, a top view of the RF MEMS switch device 1100 of Figures 8-10 is shown. In some aspects, the device 1100 may comprise a rectangular switching membrane with two fixed sides 1120, free sides 1122 and a free central area to allow for easy deflection. The switching membrane may be perforated to reduce mass and increase switching speed. In certain implementations, the perforations 1106 may be distributed across the membrane surface, with some perforations 1106 located at pillar positions 1108 in order to allow free movement of the switching membrane.

A segmentation ring 1116 may surround a central portion of the membrane in order to electrically isolate a small electrical contact 1114 disposed at the center of the membrane. In some cases, this segmentation ring 1116 may be made of silicon nitride (SiN) or other suitable insulating materials. In some aspects, the metal contact 1114 may be made of tungsten (W) or titanium tungsten (TiW) or other suitable conductive materials. The metal contact 1114 may be configured to connect RF signal lines when the switch is in a closed position. In alternative embodiments, other segmentation rings may be included on the membrane (e.g. around the perimeter of the membrane) in order to minimize parasitic capacitance.

Two RF signal paths 1102, 1104, which are also labeled as RFin and RFout, may intersect the membrane. In some implementations, metal lines 1102 and 1104 for the RF signals may be disposed either on top of or below the pull-in electrode, which is not shown in this top view. Support structures 1118 for fixing or clamping the membrane sides are depicted at two opposite sides of the device. These support structures 1118 may provide mechanical stability and define the boundary conditions for membrane movement.

The pillar structures 1108 are shown in cross-section within the membrane area. These pillars 1108 may extend from the substrate to the pull-in electrode in wafer-level encapsulated versions of the device, providing structural support while maintaining a sealed cavity as described with respect to the embodiments of Figures 8-10 above. At the pillar positions 1108, the membrane has perforation holes 1106 to help ensure that the pillars 1108 do not come in contact with the membrane, so that the membrane is not restricted in its movement.

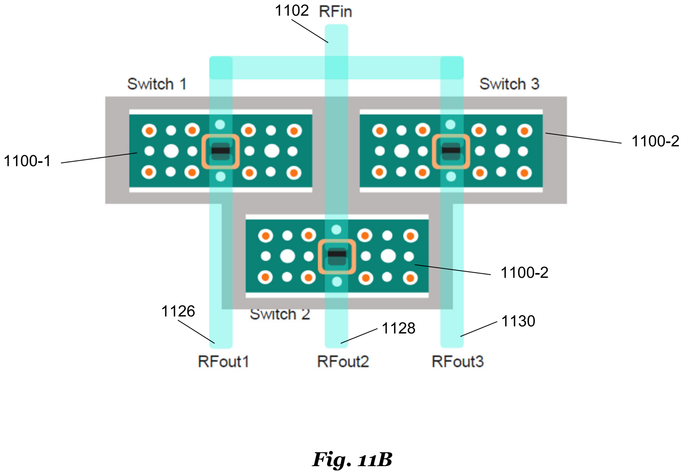

Referring to Figure 11B, a top view of an SP3T (Single Pole, Triple Throw) RF MEMS switch configuration is shown that utilizes three embodiment RF MEMS switch devices. The SP3T switch may include three individual MEMS switches 1100-1, 1100-2, 1100-3 arranged to route an input signal to one of three possible outputs.

As shown, the SP3T switch includes a single input labeled "RFin" 1102 that branches out to three outputs labeled "RFout1" 1126, "RFout2" 1128, and "RFout3" 1130. Each of the three switches is represented by a rectangular structure with a central square element and multiple circular elements arranged in a grid pattern. These circular elements correspond to perforations 1106 in the switching membrane or cross-sections of pillar structures 1108, similar to those described for the single switch configuration.

The switches may be interconnected by RF signal paths, which may be implemented as metal lines 1112 on or below the pull-in electrode layer. In some aspects, these signal paths may be designed to maintain a low impedance and minimize losses across the frequency range of interest. Each individual switch in the SP3T configuration may incorporate the same basic structure and features as any of the single switch embodiments disclosed herein. For example, in some embodiments, MEMS switches 1100-1, 1100-2, 1100-3 may be implemented as described above with respect to RF MEMS switch devices described above with respect to Figures 8-10 and 11A.

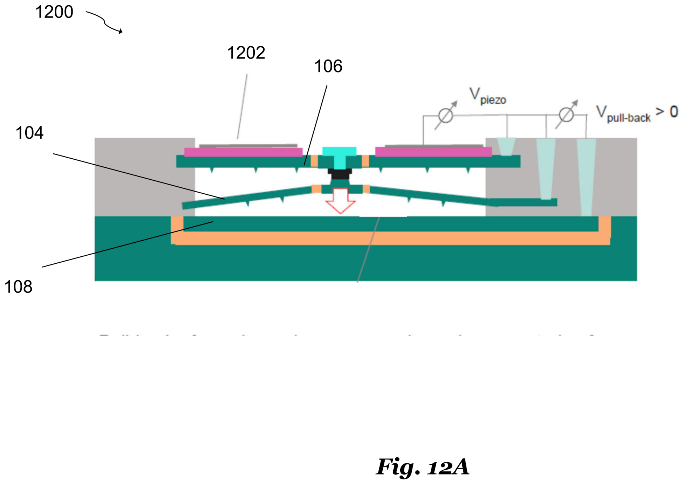

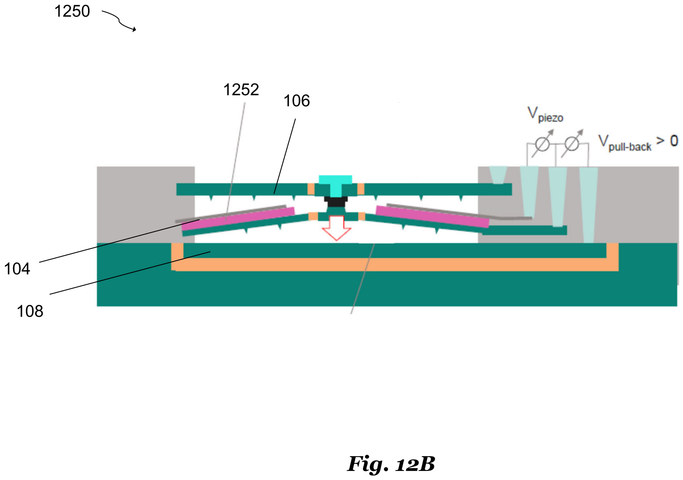

Referring to Figure 12A and Figure 12B, RF MEMS switch devices 1200, 1250 with a piezoelectric pull-off actuator may be implemented to assist in switch opening. In some aspects, the device may further comprise a piezoelectric layer 1202 disposed on or below the pull-in electrode 106 as shown in Figure 12A, or the membrane 104 as shown in Figure 12B. The piezoelectric layer 1202, 1252 may be configured to bend the switching membrane 104 downwards or to bend the pull-in electrode 106 upwards to assist in opening the switch.

In certain implementations, the piezoelectric layer 1202 may be disposed on top of the pull-in electrode 106, transforming it into a bimorphic structure capable of upward bending as shown in Figure 12A. When a voltage is applied to the piezoelectric layer 1202, it may induce a mechanical stress that causes the pull-in electrode 106 to bend upwards. This upward bending may provide an additional force to separate the metal contact 118 from the RF signal lines, complementing the mechanical restoring force of the membrane 104 and the electrostatic pull-back force. Alternatively, the piezoelectric actuator may bend the contact downwards, which brings the switching membrane 104 closer to the pull-back electrode 108, which then increases electrostatic pull-back forces for a given pull-back voltage.

The piezoelectric layer 1202, 1252 may be composed of materials such as aluminum nitride or scandium-doped aluminum nitride. These materials may be selected for their compatibility with semiconductor manufacturing processes and their ability to generate sufficient mechanical stress when electrically activated. In some cases, the thickness and composition of the piezoelectric layer 1202, 1252 may be optimized to achieve the desired bending characteristics while minimizing any impact on the overall RF performance of the switch.

In some aspects, the piezoelectric actuation may be particularly useful in overcoming contact stiction issues. When the switch is in a closed position and needs to be opened, a voltage may be applied to the piezoelectric layer 1202, 1252 in addition to activating the pull-back electrode 108. The combination of piezoelectric bending, electrostatic pull-back, and the membrane's inherent restoring force may provide a robust mechanism for ensuring reliable switch opening, even in cases where contact adhesion forces are significant.

In some embodiments, applying a voltage to a piezoelectric layer 1252 disposed on or below the switching membrane 104, as shown in Figure 12B, may assist in moving the switching membrane 104 from the closed position to the open position. When a voltage is applied, the switching membrane 104 equipped with the piezoelectric material may deform, inducing a mechanical stress in the switching membrane 104. This piezoelectric actuation may work in conjunction with the electrostatic forces and mechanical restoring forces to provide enhanced switch opening capabilities. In some implementations, the voltage applied to the piezoelectric layer 1252 may be coordinated with the voltage applied to the pull-back electrode 108 to optimize the opening process. In further embodiments, a piezoelectric layer 1252 disposed on or below the switching membrane 104 may be implemented in sealed cavity embodiments disclosed herein.

The thickness and composition of the piezoelectric layer 1252 may be tuned to achieve the desired actuation characteristics while minimizing any impact on the overall RF performance of the switch. In some cases, the piezoelectric layer 1252 may be patterned or selectively deposited to concentrate its effect in specific regions of the switching membrane 104.

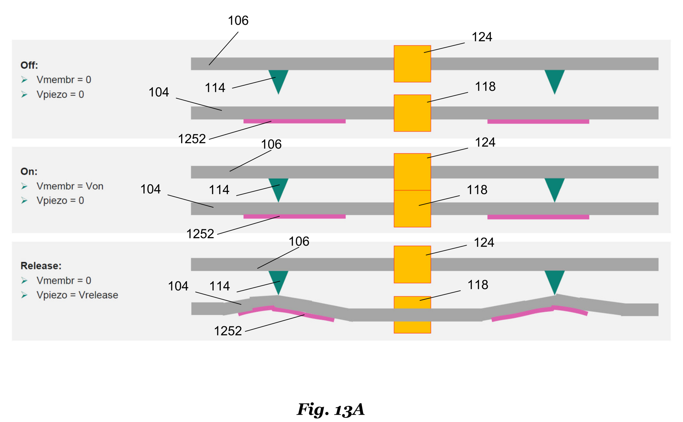

Figure 13A illustrates a sequence of operations applied to an RF MEMS switch having a piezoelectric applied to the switching membrane 104. As shown, the device may operate in an Off state, and On state and a release phase.

In the Off state, the switching membrane 104 is in its resting position, separated from the pull-in electrode 106. In this state, both the membrane voltage (Vmembr), which is the voltage between the membrane 104 and the pull-in electrode 106, and the piezoelectric voltage (Vpiezo) may be set to zero. The switch maintains high isolation between the RF signal lines in this configuration.

To transition to the On state, a voltage (Von) is applied between the switching membrane 104 and the pull-in electrode 106, that is Vmembr = Von, while maintaining Vpiezo at 0. This voltage Vmembr = Von may create an electrostatic force that pulls the membrane 104 towards the pull-in electrode 106, causing the metal contact 118 on the membrane 104 to connect the RF signal lines. The magnitude of Von may be selected based on factors such as the gap distance, membrane compliance, and desired contact force.

In some implementations, the Release phase may involve a coordinated application of voltages to facilitate switch opening. The membrane voltage Vmembr may be set back to zero, removing the electrostatic attraction between the membrane 104 and pull-in electrode 106. Simultaneously, a release voltage (Vrelease) may be applied to the piezoelectric element. This voltage may cause the piezoelectric material to deform, inducing a mechanical stress that assists in separating the metal contact 118 from the RF signal lines.

The piezoelectric actuation may provide an additional force to overcome potential stiction issues between the metal contact 118 and the RF signal lines and/or between the membrane 104 and the pull-in electrode 106. In some aspects, the magnitude and timing of Vrelease may be optimized to work in conjunction with the membrane's inherent restoring force and any pull-back electrode 108 actuation to ensure reliable switch opening.

The specific voltages used for Von and Vrelease may vary depending on the device design, materials used, and performance requirements. In some implementations, these voltages may be in the range of a few volts to tens of volts. The exact values may be tuned to balance factors such as switching speed, power consumption, and long-term reliability.

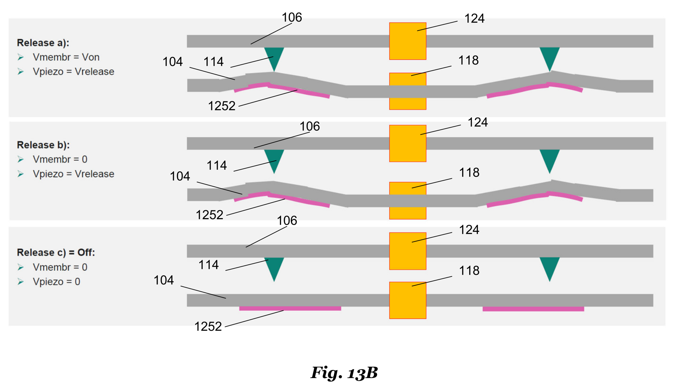

Referring to Figure 13B, an alternative sequence of operations (release stages or release phases) for achieving the Off-state of an RF MEMS switch device with piezoelectric actuation is illustrated. As shown, the release process may occur in three stages: Release a), Release b), and Release c). During Release a), the membrane voltage (Vmembr) may be maintained at Von, while a release voltage (Vrelease) is applied to the piezoelectric element. This may cause the membrane 104, which includes the piezoelectric layer, to bend away from the contact. Such a bending of the membrane 104 may initiate the separation of the metal contact 118 from the RF signal lines while the membrane 104 is still held in place by the electrostatic force.

In the Release b) stage, the membrane voltage (Vmembr) may be set to 0, removing the electrostatic attraction between the membrane 104 and the pull-in electrode 106. The piezoelectric voltage (Vpiezo) may remain at Vrelease during this stage. This combination may allow the switching membrane 104 to begin moving away from the pull-in electrode 106 while the membrane 104 maintains its bending. The release process may further be assisted by applying a voltage to the pull-back electrode 108.

The final stage, Release c), may represent the fully open or Off state. In this stage, both Vmembr and Vpiezo may be set to 0. The switching membrane 104 may return to its original flat position, such that the switching membrane 104 fully retracts to its resting state, maximizing the gap between the metal contact 118 and the RF signal lines.

In some implementations, this three-stage release process may provide enhanced control over the switch opening operation. The initial bending of the switching membrane 104 while maintaining electrostatic attraction may help overcome initial stiction forces at the contact interface. The subsequent removal of the membrane voltage followed by the relaxation of the piezoelectric bending may allow for a more gradual and controlled switch opening process.

The specific voltages and timing of each stage may be optimized based on factors such as the mechanical properties of the membrane 104 and pull-in electrode 106, the strength of any adhesion forces at the contact interface, and the desired switching speed.

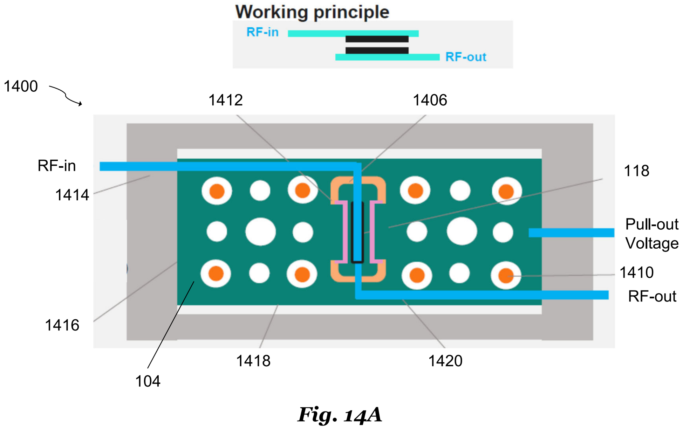

Referring to Figure 14A, a top view of an RF MEMS switch device 1400 configured as an "up-down" switch with piezoelectric pull-out functionality is shown along with a working principle diagram. As illustrated in the working principle diagram, a first metal line RF-out may be placed on the switching membrane 104, and a second metal line RF-in may be placed on the pull-out electrode 106 and coupled to respective contacts 118. Thus, when the switch is activated, the first metal line (RF-out) is electrically connected to second metal line RF-in.

In some aspects, the device may include a rectangular switching membrane 104 with fixed or clamped sides 1416 and free sides 1418. The membrane may contain an electrode area 1420 with perforation holes distributed across its surface. Some of these perforation holes may be located at pillar positions 1410. A segmentation ring 1406 may surround a central portion of the membrane 104 to provide isolation to a central contact 118. In some implementations, this segmentation ring 1406 may be made of silicon nitride (SiN) or other suitable insulating materials. The segmentation ring 1406 may serve to electrically isolate different regions of the device.

At the center of the membrane, a metal contact 118 may be disposed. In some aspects, this metal contact 118 may be made of tungsten or titanium tungsten (TiW) or other suitable conductive materials. In the vicinity of the metal contact 118, a piezoelectric element 1406 may be placed. This piezoelectric element 1406 may be configured to assist in the pull-out or opening action of the switch.

The contact area on membrane 104 is separated from electrode actuation voltage Pull-out Voltage by means of an isolating segmentation line. The membrane areas inside and outside the segmentation line may be used as electrodes for the piezoelectric element 1412, but the piezoelectric element 1406 may alternatively have its own electrodes (not shown in Figure 14A).

Around the perimeter of the membrane and across the membrane area, several pillars 1410 may be present in some embodiments. These pillars 1410 are perpendicular to the substrate and the membrane and may provide structural support and maintain the spacing between layers in the device. The membrane may be supported by structures 1416 at the fixed or clamped sides.

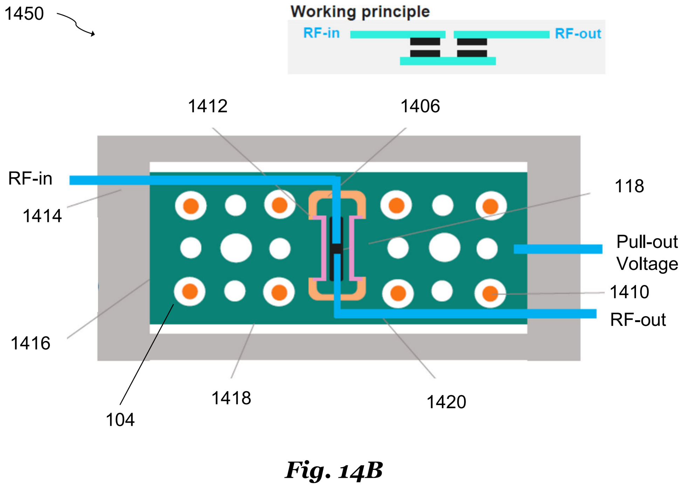

Referring to Figure 14B, an alternative configuration of an RF MEMS switch device 1450 configured as an "up-down-up" switch with piezoelectric pull-out functionality is shown. As illustrated in the working principle diagram, both the first metal line RF-out and the second metal line RF-in are placed on the pull-in electrode 106 and connected to respective contacts below the pull-in electrode 106. During operation, the first metal line RF-out and the second metal line RF-in are electrically connected via a contact on membrane 104 when RF MEMS switch device 1450 is activated. The structure of RF MEMS switch device 1450 is similar to the structure of RF MEMS switch device 1400 shown in Figure 14A with the exception of the contact structure and routing of the first metal line RF-out and the second metal line RF-in.

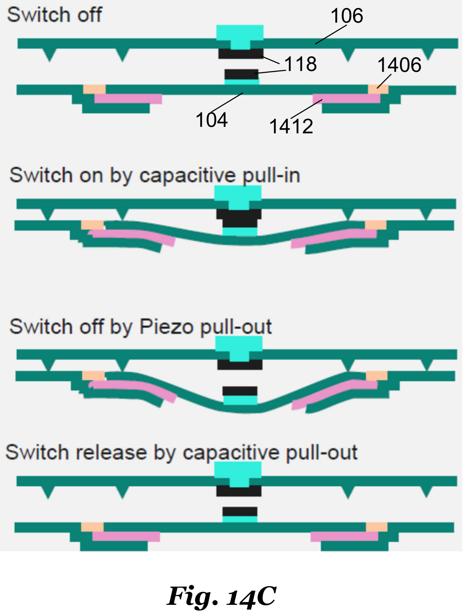

Referring to Figure 14C, cross-sectional views illustrate the operational states of the RF MEMS switches 1400 and 1450 with piezoelectric pull-out functionality. The shown cross sections are perpendicular to the metal lines RF-in and RF-out, which are at the contact position going in and out of the drawing plane. The figure shows four operational phases. In the "Switch off" state shown in the top diagram, the switching membrane 104 is in its resting position, separated from the pull-in electrode 106, with the metal contacts 118 spaced apart from each other.

In the "Switch on by capacitive pull-in" state shown in the second to top diagram, the switching membrane 104 is deflected upward due to electrostatic attraction between the membrane 104 and the pull-in electrode 106, bringing the metal contacts 118 in contact with each other, thereby electrically connecting the first metal line RF-out to the second metal line RF-in (shown in Figures 14A and 14B). The piezoelectric element 1412 remains inactive during this phase.

The "Switch off by Piezo pull-out" state shown in the second to the bottom diagram illustrates the activation of the piezoelectric element 1412, which induces bending of the switching membrane 104 to assist in separating the metal contact 118 from the RF signal lines 120. This piezoelectric actuation may help overcome contact adhesion forces and initiate the switch opening process.

The "Switch release by capacitive pull-out" state shown in the bottom diagram illustrates the final phase of switch opening, where the switching membrane 104 returns toward its resting position. In this phase, a voltage may be applied to the pull-back electrode (not shown) to generate an additional electrostatic force that assists in fully separating the contacts and returning the membrane 104 to its open state. The cross-sectional views illustrate how the layered structure of the piezoelectric element 1412 affects the membrane shape in the vicinity of the contact area during these different operational phases.

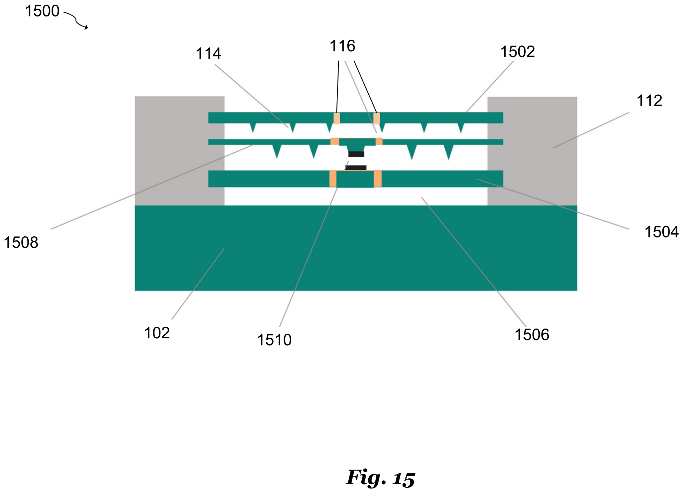

In some aspects, an RF MEMS switch device 1500 may be implemented in an "upside-down" configuration, as illustrated in Figure 15. This configuration may involve a reversal of the arrangement of various components compared to previously described embodiments.

In the upside-down configuration, a pull-back electrode 1502 may be disposed above the switching membrane 1508, while a pull-in electrode 1504 may be integrated into or disposed near the substrate 102. The switching membrane 1508 may be suspended between these two electrodes.

The pull-back electrode 1502 in this configuration may be implemented as a stiff backplate, similar to the pull-in electrode 106 in previous embodiments. This backplate may be composed of heavily doped polysilicon or other conductive materials to ensure good electrical performance. Anti-sticking bumps 114 may be incorporated on the lower surface of this pull-back electrode 1502, and segmentation lines 116 may be placed inside the pull-back electrode 1502.

In some implementations, the pull-in electrode 1504 may be integrated into the substrate 102 as a highly-doped area. Alternatively, it may be implemented as a separate conductive layer disposed on or near the substrate 102 surface. An isolation layer 1506, which may be a dielectric film or a reverse-biased pn junction, may be used to electrically isolate the pull-in electrode 1504 from the substrate 102 if necessary.

The switching membrane 1508 in this upside-down configuration may retain similar characteristics to those described in previous embodiments. It may be composed of polysilicon and may include perforations to reduce mass and improve switching speed. Metal platings or coatings 1510 for ohmic contact, such as tungsten (W) or titanium tungsten (TiW), may be disposed below the lower surface of the membrane 1508 in this configuration.

Support structures 112, which may be composed of materials like tetraethyl orthosilicate (TEOS) or silicon nitride (SiN), may be used to anchor the edges of the switching membrane 1508. These structures 112 may also incorporate contact vias for electrical connections to the various electrodes.

In operation, the upside-down configuration may function similarly to previously described embodiments, but with reversed actuation directions. To close the switch, a voltage may be applied between the switching membrane 1508 and the lower pull-in electrode 1504, causing the membrane 1508 to deflect downward. To open the switch, a voltage may be applied between the membrane 1508 and the upper pull-back electrode 1502, assisting the membrane's return to its resting position.

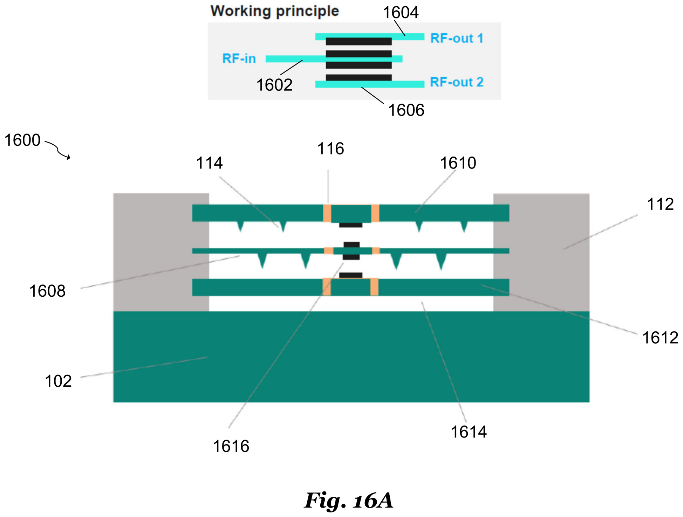

Referring to Figure 16A, an area-optimized RF MEMS Switch SPDT (Single Pole, Double Throw) 1600 with stacked switches is shown. This configuration integrates two switches in one stacked device, potentially offering advantages in terms of space efficiency and device integration. As shown, the structure includes an upper electrode 1610, a membrane 1608 and a lower electrode 1612 that may be respectively constructed in a similar manner as the pull-in electrode, membrane and pull-out electrode described with respect to other embodiments herein. In some embodiments, a cavity or a dielectric film 1614 may be disposed between the lower electrode 1612 and the substrate 102. Alternatively, the lower electrode 1612 may be implemented within the substrate 102 as a doped region. In some embodiments, the SPDT switch 1600 may be implemented using a sealed cavity, such that the top electrode 1610 is supported by pillar structures, as described above.

As shown, in the working principle diagram at the top of the figure, signal line RF-in is routed to the middle membrane layer 1608, signal line RF-out 1 1604 is routed to the top electrode 1610, and signal line RF-out 2 1606 is routed to the bottom electrode 1612. Thus, when the membrane 1608 contacts the top electrode 1610 signal lines RF-in 1602 and RF-out 1 1604 are electrically connected together, and when the membrane 1608 contacts the bottom electrode 1612 signal lines RF-in 1602 and RF-out 2 1606 are electrically connected together.

As shown, each of the top electrode 1610, membrane 1608 and lower electrode 1612 include a contact disposed thereon that is isolated from the rest of its structure via segmentation lines 116. During operation, signal line RF-in 1602 may be connected to signal line RF-out 1 1604 by applying a pull-in voltage to the top electrode 1610 such that contact on the top portion of the membrane 1608 makes contact with the contact on the top electrode 1610. Similarly, signal line RF-in 1602 may be connected to signal line RF-out 2 1606 by applying a pull-in voltage to the bottom electrode 1612 such that contact on the bottom portion of the membrane 1608 makes contact with the contact on the bottom electrode 1612. In some embodiments, a pull-out voltage may be applied to the opposite electrode when the switch is being opened. For example, after the membrane 1608 makes contact with the top electrode 1610, a pull-out voltage may be applied to the bottom electrode 1612 to pull the membrane 1608 away from the top electrode 1610. Similarly, after the membrane 1608 makes contact with the bottom electrode 1612, a pull-out voltage may be applied to the top electrode 1610 to pull the membrane 1608 away from the bottom electrode 1612.

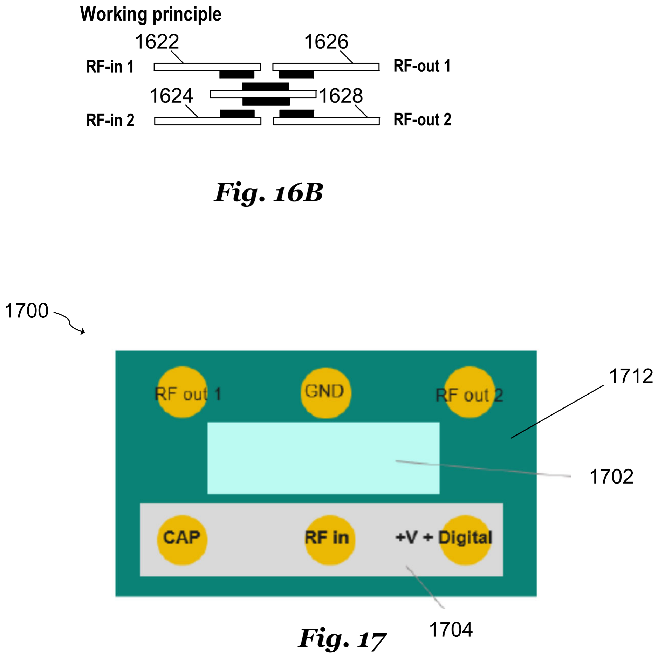

Figure 16B illustrates a diagram showing an alternative working principle for area-optimized RF MEMS Switch SPDT 1600 with stacked switches shown in Figure 16A. As shown, signal lines RF-in 1 1622 and RF-out 1 1626 are routed to respective contacts on the bottom of top electrode 1610, and signal lines RF-in 2 1624 and RF-out 2 1628 are routed to respective contacts at the top of bottom electrode 1612. Middle membrane 1608 has a contact on each side. Thus, when the membrane 1608 contacts the top electrode 1610, signal lines RF-in 1 1622 and RF-out 11626 are electrically connected together, and when the membrane 1608 contacts the bottom electrode 1612 signal lines RF-in 2 1624 and RF-out 2 1628 are electrically connected together. The configuration and working principle of Figure 16B is advantageous in that there is no need for an RF-in metal line on or below the highly flexible membrane. Instead, the metal lines RF-in 1, RF-out 1 and RF-in 2, RF-out 2 can be placed below or on the stiff and rigid backplate electrodes 1610 and 1612.

Referring to Figure 17, an architecture for integrating an RF MEMS switch with a CMOS die is shown. The diagram on the right illustrates a top view of a package 1700 that includes a die 1702 that includes an RF MEMS switch according to embodiment described herein and die 1704 that includes digital circuitry disposed on a package substrate 1712 with solder balls for external connection. In some embodiments, additional components such as a capacitor may be included. In some embodiments, the package 1700 may be a chip scale package (SCP) with SnAg solder balls. The package 1700 is shown having a dimension of 900 µm by 600 µm, however, it should be understood that this is only an example. Alternative embodiments may have different dimensions depending on the particular system, manufacturing method and specifications. In some embodiments the CMOS die 1704 is configured to provide control signals the RF MEMS switch. The package may include a single or several RF MEMS switches.

In a first embodiment, the package 1700 may be a side-by-side package that involves flipchip assembly on a laminate or interposer, or embedding in embedded Wafer Level Ball Grid Array (eWLB) with a redistribution layer. In a second embodiment, the package 1700 may be a stacked packages that includes wafer bonding of MEMS on a digital wafer or vice versa, die-to-wafer bonding, and flipchip assembly of dies. In a third embodiment, the package 1700 may be a mixed package that may involve side-by-side assembly of MEMS and CMOS on a passive interposer including a capacitor 1710.

The operating characteristics of embodiment RF MEMS switches are governed by several interrelated parameters. In the open state (RF switch OFF), the off-state capacitance Coff is determined by the ratio of the contact area (comprising the small metal contact 118 region at the membrane center) to the distance d. Reduction or Minimization of the Coff performance parameter can be achieved through the use of a small contact area in combination with a large distance d.

Switch closure (ON position) may be accomplished through electrostatic attraction between the membrane 104 and the pull-in electrode 106. The electrostatic force is proportional to the electrode area (which is substantially larger than the contact area), the square of the applied voltage, and inversely proportional to the square of the gap height g. To achieve desirable low switching voltages, the gap height can be controlled. In some embodiments, this gap height is not made excessive. In various embodiments, the gap height g is made to be larger than the open-switch contact distance d.

In various embodiments, the membrane 104 exhibits a characteristic "pull-in" behavior at a specific voltage Vp, the so-called "pull-in voltage", at which point the membrane's mechanical restoring forces can no longer balance the attractive electrostatic forces. As a result, the membrane "snaps" towards the pull-in electrode for applied voltages V which are equal or larger than the "pull-in voltage" Vp. In some embodiments, the "pull-in" operation is performed such that the contact distance d is equal to or greater than one-third of the gap height (d ≥ g/3). The square of the pull-in voltage, (Vp)², is proportional to the third power of the gap height (g³) and inversely proportional to the membrane's mechanical compliance c. Consequently, lower pull-in voltages, and thus lower operating voltages, can be achieved through the use of small gap heights and/or high membrane compliance.

Switch opening is initiated by removing the pull-in voltage between the membrane 104 and the pull-in electrode 106, allowing the membrane's mechanical restoring force to act. However, in some embodiments, adhesion forces between the contact metals 118 must be overcome for successful switch opening. The switch will open when the restoring force at the contact point (membrane center) exceeds the adhesion force. The mechanical restoring force of the membrane 104 is proportional to the center deflection (distance d) and inversely proportional to membrane compliance. The adhesion force depends on multiple factors including contact materials, surface roughness, and contact force during the ON state. Therefore, careful selection of contact metals 118 or alloys may achieve low adhesion forces and prevent contact sticking.

Embodiments of the present invention may enhance switch opening reliability through two additional mechanisms. First, a pull-back electrode 108 positioned below the membrane 104 can generate supplementary electrostatic attractive forces to assist the mechanical restoring force. Second, a piezoelectric actuation mechanism can induce upward bending of the pull-in backplate 106 to facilitate contact separation. It should be noted that the "stiff backplate," unless secured to the substrate 102 by pillars 804 as in the sealed cavity variants, may effectively function as a membrane with lower compliance than the switching membrane 104. This characteristic enables piezoelectric actuation to generate upward deflection of the pull-in electrode 106 when implemented.

The described RF MEMS switch device is particularly suited for smartphone antenna tuning applications, especially in the transition from 5G/LTE to 6G systems. The device can effectively operate across multiple frequency bands ranging from 600 MHz to 8.4 GHz. A key advantage of the design is its compatibility with standard plastic molding packaging processes, enabled by the robust pillar structure support system. This compatibility with conventional packaging represents a significant advantage in terms of manufacturing cost and complexity compared to devices requiring specialized packaging solutions.

In some aspects, the switching membrane of the RF MEMS switch device may have intrinsic tensile stress built into the material. This intrinsic stress may contribute to the mechanical restoring force of the membrane, assisting in switch opening and maintaining the membrane's flat (i.e. non-buckling) shape when not actuated. The magnitude of the intrinsic stress may be controlled during the manufacturing process through techniques such as deposition and ion implant parameters or post-deposition annealing or post-implant annealing.

The RF MEMS switch device may be operated with a voltage of approximately 10 volts in some implementations. This relatively low operating voltage may be achieved through careful optimization of factors such as gap distances, membrane compliance, and electrode areas. The ability to operate at lower voltages may provide advantages in terms of power consumption and compatibility with other low-voltage circuitry.

Embodiments of the present invention are summarized here. Other embodiments can also be understood from the entirety of the specification and the claims filed herein.

Example 1. A microelectromechanical system (MEMS) switch device, comprising: a substrate; a switching membrane disposed above the substrate; a pull-in electrode disposed above the switching membrane; a metal contact disposed on the switching membrane; and a pull-back electrode disposed below the switching membrane, wherein the switching membrane is movable between an open position and a closed position, and wherein in the closed position, the metal contact electrically connects two RF signal lines.

Example 2. The MEMS switch device of example 1, wherein the pull-back electrode is integrated into the substrate as a highly-doped area.

Example 3. The MEMS switch device of example 2, further comprising pillar structures extending from the pull-back electrode to the pull-in electrode, wherein the pillar structures provide no electrical connection between electrodes.

Example 4. The MEMS switch device of one of examples 1 to 3, further comprising anti-sticking bumps disposed on a top surface or a bottom surface of the switching membrane.

Example 5. The MEMS switch device of one of examples 1 to 4, wherein the switching membrane is perforated.

Example 6. The MEMS switch device of one of examples 1 to 5, further comprising segmentation lines electrically isolating the metal contact from the switching membrane.

Example 7. The MEMS switch device of example 1, further comprising pillar structures extending from the substrate to the pull-in electrode, wherein the pillar structures provide no electrical connection between electrodes.

Example 8. The MEMS switch device of example 7, further comprising a sealed vacuum cavity between the pull-in electrode and the substrate.

Example 9. The MEMS switch device of one of examples 1 to 8, further comprising a piezoelectric layer disposed on or below the switching membrane.

Example 10. The MEMS switch device of example 9, wherein the piezoelectric layer is configured to bend the switching membrane downwards to assist in opening the switch.

Example 11. The MEMS switch device of one of examples 1-10, further comprising a piezoelectric layer disposed on or below the pull-in electrode.

Example 12. The MEMS switch device of one of examples 1-11, wherein the metal contact is made of titanium tungsten (TiW).

Example 13. A packaged MEMS switch product comprising: the MEMS switch device of example 1; and an integrated circuit coupled to the MEMS switch device, wherein the MEMS switch device and the integrated circuit are enclosed in a package.

Example 14. The packaged MEMS switch product of example 13, wherein the integrated circuit comprises a digital CMOS integrated circuit configured to provide control signals to the MEMS switch device.

Example 15. The packaged MEMS switch product of example 13 or 14, wherein the MEMS switch device and the integrated circuit are arranged side-by-side on a substrate.

Example 16. The packaged MEMS switch product of example 15, wherein the substrate is a laminate or interposer.

Example 17. The packaged MEMS switch product of one of examples 13-16, wherein the MEMS switch device is stacked on the integrated circuit.

Example 18. The packaged MEMS switch product of one of examples 13-17, wherein the package is a chip scale package (CSP) with solder balls.

Example 19. A method of operating a microelectromechanical system (MEMS) switch device, comprising: applying a first voltage between a switching membrane and a pull-in electrode to move the switching membrane from an open position to a closed position, wherein in the closed position a metal contact on the switching membrane electrically connects two RF signal lines disposed on the pull-in electrode; and applying a second voltage between the switching membrane and a pull-back electrode to move a switch formed by the metal contact and the RF signal lines from the closed position to the open position.

Example 20. The method of example 19, further comprising applying a voltage to a piezoelectric layer disposed on the switching membrane or on the pull-in electrode to assist in moving the switch from the closed position to the open position.

Example 21. The method of example 19 or 20, wherein the switching membrane is perforated to reduce mass and increase switching speed.

Example 22. The method of one of examples 19-21, further comprising maintaining a sealed vacuum cavity between the pull-in electrode and a substrate to protect the switch from environmental contaminants.

Example 23. The method of example 22, wherein the sealed vacuum cavity is supported by pillar structures extending from the substrate to the pull-in electrode.

Example 24. A wafer-level encapsulated microelectromechanical system (MEMS) switch device, comprising: a substrate; a switching membrane disposed above the substrate; a pull-in electrode disposed above the switching membrane; a metal contact disposed on the switching membrane; a sealed cavity enclosing the switching membrane; and pillar structures extending from the substrate to support the pull-in electrode, wherein the switching membrane is movable between an open position and a closed position within the sealed cavity.

Example 25. The wafer-level encapsulated MEMS switch device of example 24, further comprising a pull-back electrode disposed below the switching membrane, wherein the pull-back electrode is configured to assist in moving the switching membrane from the closed position to the open position.

Example 26. The wafer-level encapsulated MEMS switch device of example 24 or 25, wherein the pull-back electrode is integrated into the substrate as a highly-doped area.

Example 27. The wafer-level encapsulated MEMS switch device of one of examples 24-26, further comprising a piezoelectric layer disposed on the switching membrane, wherein the piezoelectric layer is configured to assist in moving the switching membrane from the closed position to the open position.

Example 28. A microelectromechanical system (MEMS) single pole double throw (SPDT) switch device, comprising: an upper pull-in electrode comprising a first electrical contact; a switching membrane disposed below the upper pull-in electrode and comprising a second electrical contact disposed on a first surface of the switching membrane facing the upper pull-in electrode, and a third electrical contact disposed on a second surface of the switching membrane opposite the first surface; and a lower pull-in electrode disposed below the switching membrane and comprising a fourth electrical contact, wherein the switching membrane is movable between a first position in which the first electrical contact makes physical contact with the second electrical contact, and a second position in which the third electrical contact makes contact with the fourth electrical contact.

Example 29. The MEMS SPDT switch device of example 28, wherein:
the first position is configured to be achieved by applying a pull-in voltage to the upper pull-in electrode; and the second position is configured to be achieved by applying a pull-in voltage to the lower pull-in electrode.

Example 30. The MEMS SPDT switch device of example 28 or 29, further comprising: a first conductive line disposed on the membrane and electrically connected to the second contact and the third contact; a second conductive line disposed on the upper pull-in electrode and electrically connected to the first contact; and a third conductive line disposed on the lower pull-in electrode and electrically connected to the fourth contact.

Example 31. The MEMS SPDT switch device of example 28 or 29, wherein the upper pull-in electrode further comprises a fifth contact, the lower pull-in electrode further comprises a sixth contact, and the MEMS SPDT switch device further comprises: a first conductive line disposed on the upper pull-in electrode and electrically connected to first contract; a second conductive line disposed on the upper pull-in electrode and electrically connected to fifth contract; a third conductive line disposed on the lower pull-in electrode and electrically connected to the fourth contact; and a fourth conductive line disposed on the lower pull-in electrode and electrically connected to the sixth contact.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A microelectromechanical system switch device, comprising:
a substrate;
a switching membrane disposed above the substrate;
a pull-in electrode disposed above the switching membrane;
a metal contact disposed on the switching membrane; and
a pull-back electrode disposed below the switching membrane, wherein the switching membrane is movable between an open position and a closed position, and wherein in the closed position, the metal contact electrically connects two RF signal lines.

2. The microelectromechanical system switch device of claim 1, wherein the pull-back electrode is integrated into the substrate as a highly-doped area.

3. The microelectromechanical system switch device of claim 2, further comprising pillar structures extending from the pull-back electrode to the pull-in electrode, wherein the pillar structures provide no electrical connection between electrodes.

4. The microelectromechanical system switch device of any one of claims 1 to 3, further comprising anti-sticking bumps disposed on a top surface or a bottom surface of the switching membrane.

5. The microelectromechanical system switch device of any one of claims 1 to 4, wherein the switching membrane is perforated.

6. The microelectromechanical system switch device of any one of claims 1 to 5, further comprising one or more of:
- segmentation lines electrically isolating the metal contact from the switching membrane;
- pillar structures extending from the substrate to the pull-in electrode, wherein the pillar structures provide no electrical connection between electrodes,
- a sealed vacuum cavity between the pull-in electrode and the substrat,
- a piezoelectric layer disposed on or below the switching membrane, wherein optionally the piezoelectric layer is configured to bend the switching membrane downwards to assist in opening the switch, or
- a piezoelectric layer disposed on or below the pull-in electrode.

7. The microelectromechanical system switch device of any one of claims 1 to 6, wherein the metal contact is made of titanium tungsten.

8. A packaged microelectromechanical system switch product comprising:
the microelectromechanical system switch device of any one of claims 1 to 7; and
an integrated circuit coupled to the microelectromechanical system switch device, wherein the microelectromechanical system switch device and the integrated circuit are enclosed in a package.

9. The packaged microelectromechanical system switch product of claim 8, wherein the integrated circuit comprises a digital CMOS integrated circuit configured to provide control signals to the microelectromechanical system switch device.

10. The packaged microelectromechanical system switch product of claim 8 or 9, wherein the microelectromechanical system switch device and the integrated circuit are arranged side-by-side on a substrate, wherein optionally the substrate is a laminate or interposer.

11. The packaged microelectromechanical system switch product of any one of claims 8 to 10, wherein:
- the microelectromechanical system switch device is stacked on the integrated circuit; and/or
- the package is a chip scale package with solder balls.

12. A method of operating a microelectromechanical system switch device, comprising:
applying a first voltage between a switching membrane and a pull-in electrode to move the switching membrane from an open position to a closed position, wherein in the closed position a metal contact on the switching membrane electrically connects two RF signal lines disposed on the pull-in electrode; and
applying a second voltage between the switching membrane and a pull-back electrode to move a switch formed by the metal contact and the RF signal lines from the closed position to the open position.

13. The method of claim 12, further comprising applying a voltage to a piezoelectric layer disposed on the switching membrane or on the pull-in electrode to assist in moving the switch from the closed position to the open position.

14. The method of claim 12 or 13, wherein the switching membrane is perforated to reduce mass and increase switching speed.

15. The method of any one of claims 12 to 14, further comprising maintaining a sealed vacuum cavity between the pull-in electrode and a substrate to protect the switch from environmental contaminants, wherein optionally the sealed vacuum cavity is supported by pillar structures extending from the substrate to the pull-in electrode.
